Europäisches Patentamt

European Patent Office

Office européen des brevets

(11) Veröffentlichungsnummer: **0 252 489**
**A2**

## EUROPÄISCHE PATENTANMELDUNG

(21) Anmeldenummer: **87109784.6**

(22) Anmeldetag: **07.07.87**

(51) Int. Cl.⁴: **H01L 31/02** , H05B 3/26

(30) Priorität: **11.07.86 DE 3623497**
 **17.02.87 DE 3704880**

(43) Veröffentlichungstag der Anmeldung:
 **13.01.88 Patentblatt 88/02**

(84) Benannte Vertragsstaaten:
 **BE CH DE ES FR GB IT LI SE**

(71) Anmelder: **Nukem GmbH**
 **Rodenbacher Chaussee 6 Postfach 11 00 80**
 **D-6450 Hanau 11(DE)**

(72) Erfinder: **von Campe, Hilmar**
 **Jacob-Lengfelder-Strasse 19**
 **D-6380 Bad Homburg(DE)**
 Erfinder: **Hoffmann, Winfried**
 **Bergstrasse 48**
 **D-6450 Hanau(DE)**

(74) Vertreter: **Stoffregen, Hans-Herbert, Dr.**
 **Dipl.-Phys. et al**
 **Patentanwälte Strasse & Stoffregen**
 **Salzstrasse 11a**
 **D-6450 Hanau(DE)**

(54) Transparentes, leitfähiges Schichtsystem.

(57) Es wird ein transparentes, leitfähiges Schichtsystem (10) insbesondere für Solarzellen oder heizbare Fensterelemente (11) vorgeschlagen, das eine gute elektrische Leitfähigkeit und eine hohe Transparenz bietet, indem zwischen zwei eine leitfähige Schwermetallverbindung enthaltenden Halbleiterschichten (12, 16) eine Metallschicht (14) angeordnet wird. Der Flächenwiderstand der Halbleiterschichten beträgt dabei weniger als $40\Omega/\square$.

Fig. 1

## Transparentes, leitfähiges Schichtsystem

Die Erfindung bezieht sich auf ein transparentes, leitfähiges Schichtsystem insbesondere für Solarzellen oder heizbare Fensterelemente mit wenigstens einer zwischen Halbleiterschichten angeordneten Metallschicht.

Transparente, leitfähige Schichten werden beispielsweise bei der Herstellung von Widerständen, heizbaren Fenstern, antistatischen Fenstern, transparenten Elektroden, Infrarot-Reflektoren, optischen Filtern und selektiven Sensoren verwendet (K.L. Chopra, S. Major, D.K. Pandya, Thin Solid Films 102 (1983) 1).

Als Materialien werden entweder Metalle wie Gold, Silber, Platin oder transparente, leitfähige Oxide wie Cadmiumstannat, Zinnoxid oder Indiumoxid benutzt, die auch als TCO ( = Transparent Conductive Oxides, bezeichnet werden. Zur Gruppe der TCO-Materialien zählen beispielsweise: $SnO_2$ ( = TO = tin oxide); $SnO_2$ : Sb ( = ATO = antimony doped tin oxide); $SnO_2$ : F ( = FTO = fluorine doped tin oxide); $In_2O_3$ : Sn, u.a. ( = ITO = indium tin oxide).

Als Dotierstoffe für Indiumoxid sind außer Zinn auch Titan, Antimon, Fluor sowie Fluor und Zinn gemeinsam bekannt.

Ferner ist die Kombination von Metallschichten mit schlecht leitenden Oxiden oder Sulfiden bekannt. Auch stellt die Einbettung einer dünnen Silberschicht zwischen zwei Zinnoxidschichten bei einer heizbaren Frontscheibe Bekanntes dar. Um antistatische Fenster herzustellen genügt es, eine TCO-Schicht mit relativ niedriger Leitfähigkeit zu verwenden, so daß die Transparenz nur wenig in Mitleidenschaft gezogen wird. Bei einer heizbaren Frontscheibe oder bei einer a-Si-Solarzelle muß neben einer hohen Transparenz auch ein niedriger elektrischer Widerstand gegeben sein. Eine hohe Leitfähigkeit ist jedoch bei Verwendung von TCO-Schichten nur mit einer hohen Schichtdicke zu erreichen.

Eine höhere Leitfähigkeit kann mit dünnen Metallschichten erzielt werden, die bereits bei Schichtdicken von 10 nm einen Flächenwiderstand von 10 $\Omega$ / $\square$ erreichen. Allerdings liegt die Transmission einer auf Glas aufgedampften Metallschicht mit einer Schichtdicke d<30 nm bereits unter 50%.

Aufgabe der vorliegenden Erfindung ist es, ein transparentes, leitfähiges Schichtsystem der eingangs beschriebenen Art so auszubilden, daß sowohl eine gute elektrische Leitfähigkeit als auch hohe Transparenz gegeben ist.

Die Aufgabe wird erfindungsgemäß dadurch gelöst, daß die Halbleiterschichten eine leitfähige oxidische Schwermetallverbindung enthalten und einen Flächenwiderstand von weniger als 40 $\Omega$ / $\square$ aufweisen.

Durch das erfindungsgemäße Schichtsystem ergibt sich der Vorteil, daß gleichzeitig die elektrische Leitfähigkeit wie bei einer dickeren Metallschicht und die optische Durchlässigkeit wie bei einer dünneren Metallschicht erreicht werden.

Die Transmission des Schichtsystems ist besonders hoch, wenn die der Metallschicht benachbarten Halbleiterschichten einen hohen Brechungsindex aufweisen. Dies wird vorteilhafterweise dadurch erreicht, daß wenigstens eine der Halbleiterschichten eine oxidische Zinnverbindung enthält.

Nach einem besonders hervorzuhebenden Vorschlag der Erfindung ergibt sich eine gute elektrische Leitfähigkeit und gleichzeitig eine hohe optische Transmission dann, wenn die Halbleiterschichten mit Zinndioxid versetztes Indiumoxid aufweisen. Als Material für die Halbleiterschichten kann ebenso mit Fluor oder mit Antimon dotiertes Zinndioxid verwendet werden.

Derartige Halbleiterschichten wirken bei einem beispielsweise auf Glas oder Acrylglas als Substrat aufgebrachten Schichtsystem zugleich als reflexionsmindernde Schicht und können durch Anpassung ihrer Schichtdicke für ein bestimmtes Transmissionsmaximum optimiert werden. Dabei muß die optische Schichtdicke n $\bullet$ d gleich oder gleich einem Vielfachen der halben Wellenlänge $\lambda$ des durchgelassenen Lichtes sein. Für eine Wellenlänge von $\lambda$ = 550 nm ergibt sich bei einer Brechzahl von n$\approx$2 eine Schichtdicke von rund 140 nm. Der elektrische Widerstand einer solchen Schicht beträgt rund 10 $\Omega$ / $\square$. Wird diese Schicht nun in zwei Hälften von je 70 nm Dicke aufgeteilt und dazwischen eine Metallschicht von 5 bis 30 nm Dickt mit einem Flächenwiderstand von 20 $\Omega$ / $\square$ bis 3 $\Omega$ / $\square$ angeordnet, so läßt sich ein Flächenwiderstand im Bereich von 7 $\Omega$ / $\square$ bis 2 $\Omega$ / $\square$ errreichen, wobei die Transparenz dieses Schichtsystems wesentlich höher liegt also die einer gleich dicken Metallschicht ohne benachbarte Halbleiterschichten.

Um Reflexionsverluste insbesondere an der an luft grenzenden äußeren Grenzfläche zu vermeiden, wenn als die Halbleiterschicht mit einer Brechzahl n = 2 an das Medium Luft mit n = 1 grenzt, wird in Ausgestaltung der Erfindung vorgeschlagen, daß wenn eine oder mehrere Übergangsschichten über der Halbleiterschicht anordbar sind, deren Brechungsindizes abnehmende Werte besitzen. Ebenso können Reflexionsverluste zwischen der zweiten Halbleiterschicht und dem Substrat vermindert werden, wenn zwischen diesen ebenfalls eine Übergangsschicht angeordnet ist, deren Brechungsindex zwischen dem der Halbleiterschicht und dem des Mediums liegt.

# 0 252 489

Insbesondere zeigt sich eine verbesserte Transmission bei folgender Anordnung des Schichtsystems:

$$\text{MgF} \ / \ \text{Glassubstrat} \ / \ \text{ITO} \ / \ \text{Ag} \ / \ \text{ITO} \ / \ \text{SiO}_2 \ / \ \text{MgF}$$
$$n_i \quad 1,3 \ / \qquad 1,5 \qquad / \ 2 \ / \ n(d)/ \ 2 \ / \ 1,5 \ / \ 1,3$$

Besonders günstig ist es, wenn die Übergangsschichten keinen konstanten Brechungsindex aufweisen, sondern einen Brechungsindex-Gradienten aufweisen, wobei der Brechungsindex von der Halbleiterschicht zum Medium hin abnimmt.

Ein reflexionsmindernd optimiertes Schichtsystem mit der Schichtanordnung ITO/Ag/ITO weist beispielsweise bei einer Dicke der Silberschicht von 10 nm einen Flächenwiderstand von 7 Ω / ☐ und eine Transmission von über 70% auf. Die Schichtdicke der Halbleiterschichten liegt vorteilhafterweise zwischen 10 und 1000 nm, vorzugsweise zwischen 50 und 500 nm. Als Material wird vorteilhafterweise mit Zinnoxid versetzes Indiumoxid eingesetzt. Die Schichtdicke der Metallschicht kann je nach geforderter Leitfähigkeit und Transmission zwischen 1 und 100 nm variieren. Bevorzugt wird jedoch eine Schichtdicke zwischen 5 und 30 nm. Für die Metallschicht ist ein Material aus der Gruppe Kupfer, Silber, Gold, Platin, Aluminium, Chrom, Eisen oder Nickel empfehlenswert. Diese können daher als reine Metalle oder als Legierungen bzw. Mischungen eingesetzt werden.

Für die reflexionsmindernden Schichten können aus der optischen Anwendung bekannte Materialien wie Siliziumdioxid, Aluminiumoxid oder Magnesiumfluorid verwendet werden.

Bei der Verwendung des erfindungsgemäßen Schichtsystems beispielsweise für eine heizbare Fensterscheibe werden zwei einander gegenüberliegende streifenförmige Abschnitte am Rande der Scheibe mit metallischen Kontakten auf der obersten Halbleiterschicht versehen, welche mit den elektrischen Anschlüssen verbindbar sind.

Bei einer Solarzelle beginnt der Schichtaufbau auf einem später als Abdeckscheibe dienenden Substrat mit einer vorzugsweise ITO enthaltenden Halbleiterschicht von 10 bis 1000 nm Stärke. Dieser folgt eine 1 bis 100 nm, vorzugsweise 5 bis 30 nm starke Metallschicht aus der Gruppe der oben genannten Metalle. Auf die Metallschicht wird photoempfindliches Material wie z.B. Silizium aufgebracht, das z.B. zur Metallschicht hin p-dotiert und zur Rückseite hin n-dotiert ist. Auf der Rückseite der Silizium-Schicht kann eine Metallschicht als Rückkontakt angeordnet sein, deren Schichtdicke unter 5 bis 30 nm betragen sollte, wenn die Solarzelle sowohl von der Vorderseite als auch von der Rückseite her einstrahlendes Licht in elektrische Energie umwandeln soll. Sofern die Solarzelle nur Strahlung von der Vorderseite erfassen soll, so kann der Rückkontakt beliebig dick ausgebildet sein und gleichzeitig als Substrat dienen.

Weitere Einzelheiten, Vorteile und Merkmale der Erfindung ergeben sich nicht nur aus den Ansprüchen, den diesen zu entnehmenden Merkmalen -für sich und/oder in Kombination-sondern auch aus der nachfolgenden Beschreibung von in der Zeichnung dargestellten bevorzugten Ausführungsbeispielen.

Es zeigen:

Fig. 1 einen Querschnitt eines für die Heizung von Fensterelementen bestimmten erfindungsgemäßen Schichtsystems in schematischer Darstellung und

Fig. 2 einen Querschnitt durch ein erfindungsgemäßes Schichtsytem in einer Solarzelle in schematischer Darstellung.

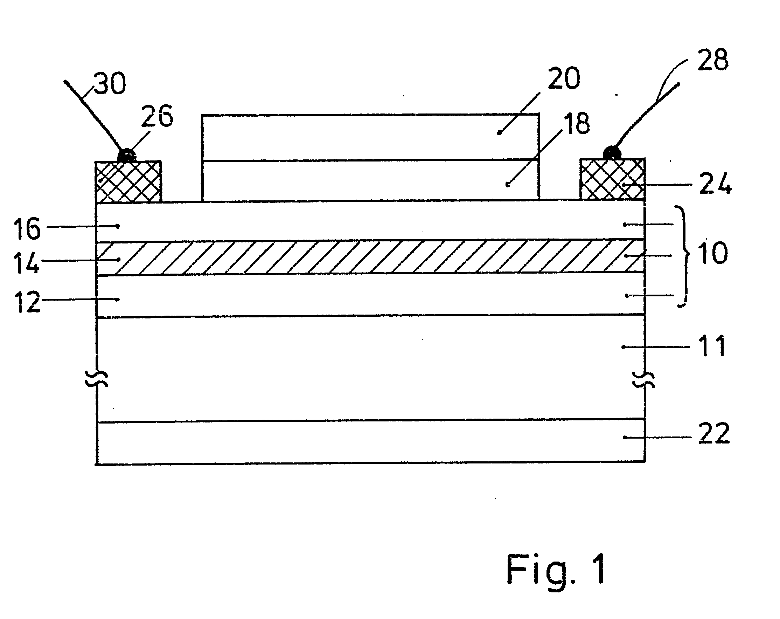

In Fig. 1 ist in schematischer Darstellung ein Schichtsystem (10) dargestellt, das als Heizung für ein Fensterelement (11) bestimmt ist. Das auch als Substrat zu bezeichnende Fensterelement (11), das eine Glasscheibe oder auch eine Folie sein kann, weist auf seiner oberen Seite eine Halbleiterschicht (12) auf, die aus mit Zinnoxid versetztem Indiumoxid bestehen kann. Die Schichtdicke der Halbleiterschicht (12) beträgt etwa 70 nm. Auf die Halbleiterschicht (12) ist eine Metallschicht (14) aufgebracht, die aus Silber bestehen und eine Dicke von 15 nm aufweisen kann. Die Metallschicht (14) wird sodann von einer weiteren (zweiten) Halbleiterschicht (16) abgedeckt, die ebenfalls wie die Halbleiterschicht (12) eine Dicke von 70 nm aufweisen und aus mit Zinnoxid versetztem Indiumoxid bestehen kann.

Um etwaige Reflexionsverluste zu vermindern, kann ferner auf die Halbleiterschicht (16) eine dielektrische Schicht (18) zum Beispiel aus Siliziumoxid aufgebracht werden, deren Brechungsindex kleiner als der Brechungsindex der Halbleiterschicht (16) ist. Die Dicke der dielektrischen Schicht (18) kann dabei z.B. 180 nm betragen. Eine weitere Reflexionsverminderung kann nun dadurch erreicht werden, indem zusätzlich sowohl auf die dielektrische Schicht (18) als auch auf die Unterseite des Substrats (11) jeweils noch eine weitere Schicht (20) bzw. (22) aufgetragen wird, deren Brechungsindex geringer als der der abgedeckten Schichten ist. Als geeignetes Material für die Schichten (20) und (22) ist Magnesiumfluorid zu erwähnen, deren Schichtdicke 210 nm betragen kann.

3

Ferner ist auf den Seitenkanten des aus den Schichten (12), (14) und (16) aufgebauten Schichtsystems (10) jeweils ein Kontaktstreifen (24) bzw. (26) aufgebracht, der jeweils mit einer Zuleitung (28) bzw. (30) verbunden ist. Über die Zuleitung (28) und (30) und die Kontaktstreifen (24) und (26) wird zu dem Schichtsystem (10), vorzugsweise zu der Metallschicht (14) elektrischer Strom geleitet, um eine Aufheizung des Substrats (11) zu bewirken.

Durch das erfindungsgemäße Schichtsystem kann die zur Erwärmung erforderliche elektrische Leistung schon bei kleinen Spannungen (Z.B. 12 V) eingespeist werden. Der erfindungsgemäße Aufbau des Schichtsystem (10) stellt des weiteren sicher, daß die Transparenz nicht merklich beeinträchtigt wird.

Die bei der Herstellung von bekannten Schichtstrukturen bestehen aus Dielektrikum-Metall-Dielektrikum verwendeten Materialien der äußeren Schichten sind Isolatoren. Demzufolge bereitet die Kontaktierung der Schichtstruktur bei kleinen Kontaktflächen Probleme. Kleine Kontaktflächen sind aber Voraussetzung für eine hohe Transparenz der gesamten Anordnung. Durch das erfindungsgemäße Schichtsystem können jedoch die erforderlichen Stromdichten auch bei kleinen Kontaktflächen eingeprägt werden, so daß eine merkliche Beeinflussung der Transparenz nicht erfolgt.

Bei einem erfindungsgemäßen Schichtsystem kann z.B. auf der Rückseite einer ITO-Schicht im z.B. Siebdruckverfahren, PVD-/CVD-Beschichtungsverfahren, durch galvanische Verfahren oder durch Plasmaspritzen (Flammenspritzen) zwei lötbare elektrische Kontaktbahnen hergestellt werden, an die Zuleitungen anlötbar sind.

Bei dem der Fig. 1 zu entnehmenden Aufbau weisen die Brechungsindizes der einzelnen Schichten folgende Werte auf:

Das Substrat (11), sofern es sich um Glas handelt, hat den Brechungsindex n = 1,5, die Halbleiterschichten (12) und (16) den Brechungsindex n = 2, die dielektrische Schicht (18) in Form von $SiO_2$ hat den Brechungsindex n = 1,5 und die Antireflexionsschicht (20) bzw. (22) in Form von Magnesiumfluorid den Brechungsindex n = 1,3.

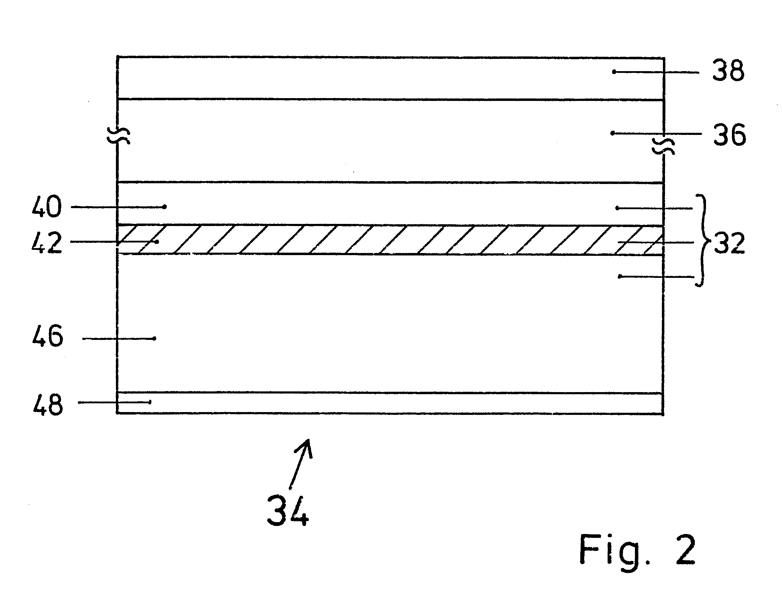

Der Fig. 2 ist ein erfindungsgemäßes Schichtsystem (32) zu entnehmen, das in einer Solarzelle (34) eingesetzt wird. In der Solarzelle (34) wird mit dem Bezugszeichen (36) eine Abdeckscheibe bezeichnet, die gleichzeitig als Träger des Schichtsystems (32) dient. Die Abdeckscheibe besteht dabei vorzugsweise aus Glas und hat einen Brechnungsindex n = 1,5.

Nach außen wird die Abdeckung (36) mit einer reflexionsmindernden Schicht (38) abgedeckt, die vorzugsweise aus Magnesiumfluorid besteht, einen Brechungsindex n = 1,3 aufweist und eine Schichtdicke von 10 bis 280 nm, vorzugsweise von 20 bis 100 nm umfaßt. Die Innenseite der Abdeckung (36) ist mit einer Halbleiterschicht (40) versehen, die aus mit Zinnoxid versetztem Indiumoxid eine Dicke von vorzugsweise 70 nm besteht und die einen Brechungsindex n = 2 besitzt. Auf der der Abdeckung (36) abgewandten Seite der Halbleiterschicht (40) befindet sich eine Metallschicht (42), vorzugsweise in Form von Silber mit einer Dicke von 20 nm. Über der Schicht (42) ist eine Schicht (46) aus photoempfindlichem Material wie Solarsilizium angeordnet, das in dem der Metallschicht (42) zugewandten Bereich z.B. p-dotiert und in dem gegenüberliegenden, also rückseitigen Bereich n-dotiert ist. Schließlich wird die Siliziumschicht (46) außenseitig von einem elektrisch leitfähigen Rückkontakt (48) in Form einer Metallschicht aus z.B. Aluminium mit der Dicke von 0,5 bis 2 $\mu$m abgedeckt.

An Stelle der im Ausführungsbeispiel beschriebenen Solarzelle (34) mit einer als Trägersubstrat dienenden Abdeckung (36) und einer relativ dünnen Siliziumschicht (46) kann selbstverständlich das erfindungsgemäße Schichtsystem auch in Solarzellen benutzt werden, deren Siliziumschicht dicker, z.B. in Form einer Siliziumscheibe, gewählt ist, so daß diese als Träger für das Schichtsystem (32) dient. In diesem Fall ist das Substrat (36) nicht mehr erforderlich, kann aber durch eine Schicht aus $SiO_2$ mit n = 1,5 ersetzt werden.

## Ansprüche

1. Transparentes, leitfähiges Schichtsystem insbesondere für Solarzellen oder heizbare Fensterelemente mit wenigstens einer zwischen Halbleiterschichten angeordneten Metallschicht,
**dadurch gekennzeichnet,**
daß die Halbleiterschichten (12, 16, 40) eine leitfähige oxidische Schwermetallverbindung enthalten und einen Flächenwiderstand von weniger als 40 $\Omega$ / $\square$ aufweisen.

2. Schichtsystem nach Anspruch 1,
**dadurch gekennzeichnet,**
daß wenigstens eine der Halbleiterschichten (12, 16, 40) eine oxidische Zinnverbindung enthält.

4

3. Schichtsystem nach Anspruch 2,

**dadurch gekennzeichnet ,**

daß wenigstens eine der Halbleiterschichten (12, 16, 40) mit Zinndioxid versetztes Indiumoxid enthält.

4. Schichtsystem nach Anspruch 2,

**dadurch gekennzeichnet,**

daß wenigstens eine der Halbleiterschichten (12, 16, 40) mit Fluor oder mit Antimon dotiertes Zinndioxid enthält.

5. Schichtsystem nach Anspruch 2,

**dadurch gekennzeichnet,**

daß zwischen einem an dem Schichtsystem (10) angrenzenden Medium wie Luft und der zugewandten Halbleiterschicht (12, 16) wenigstens eine Übergangsschicht (18, 20, 11, 22) angeordnet ist, deren Brechungsindex zwischen dem der Halbleiterschicht und dem des Mediums liegt.

6. Schichtsystem nach Anspruch 5,

**dadurch gekennzeichnet,**

daß der Brechungsindex der Übergangsschicht (18, 20, 22) in Richtung ihrer Flächennormalen einen vom Brechungsindex der Halbleiterschicht (12, 16) zum Brechungsindex des Mediums abnehmenden Gradienten aufweist.

7. Schichtsystem nach Anspruch 1,

**dadurch gekennzeichnet,**

daß die Schichtdicke der Metallschicht (14, 42) im Bereich von 5 bis 100 nm liegt.

8. Schichtsystem nach Anspruch 7,

**dadurch gekennzeichnet,**

daß die Metallschicht (14, 42) ein Metall oder eine Metallegierung aus der Gruppe Kupfer, Silber, Gold, Platin, Aluminium, Chrom, Eisen oder Nickel enthält.

9. Schichtsystem in Form eines heizbaren durchsichtigen Substrats wie Scheibe,

**dadurch gekennzeichnet,**

daß auf einer Außenfläche des Substrats (11) schichtweise übereinander eine transparente erste Halbleiterschicht (12), eine weniger als 30 nm dicke Metallschicht (14), eine transparente zweite Halbleiterschicht (16) und vorzugsweise eine Siliziumdioxid-Schicht (128) angeordnet sind, wobei die Hableiterschichten (12, 16) z.B. mit Zinnoxid versetztes Indiumoxid oder Antimon oder Fluor dotiertes Zinnoxid enthalten.

10. Schichtsystem in Form einer Solarzelle,

**dadurch gekennzeichnet ,**

daß auf einer Außenfläche eines transparenten Substrats wie Abdeckung (36) übereinander eine mit Zinnoxid versetztes Indiumoxid oder Antimon oder Fluor dotiertes Zinnoxid enthaltende transparente Halbleiterschicht (40), eine weniger als 100 nm dicke Metallschicht (42), und eine Schicht (46) aus photoempfindlichem Material, das einen pn-Übergang enthält oder photoleitend ist, und eine elektrisch leitfähige Metallschicht (48) angeordnet sind.

11. Schichtsystem nach Anspruch 9 oder 10,

**dadurch gekennzeichnet,**

daß zumindest auf der an Luft grenzenden Außenfläche des Schichtsystems (10) eine Magnesiumfluorid-Schicht (20) und an der an Luft grenzenden Außenfläche des Trägers (11, 36) eine Magnesiumfluorid-Schicht (22, 38) angeordnet ist.

12. Schichtsystem nach Anspruch 10,

**dadurch gekennzeichnet ,**

daß das photoempfindliche Material z.B. a-Si, c-Si oder GaAs oder CdS, ZnS, CuInSe$_2$, Cu$_2$S oder eine Kombination dieser ist.

Fig. 1

38 36 32 34 40 42 46 48

Fig. 2